# EUROPEAN PATENT SPECIFICATION

(11) **EP 4 168 466 B1**
(45) Date of publication and mention of the grant of the patent: **31.07.2024**
(21) Application number: 21730573.9
(22) Date of filing: 03.06.2021
(51) Int. Cl.: C08G 59/02

(54) **A PHOTOCURABLE COMPOSITION**
EINE FOTOHÄRTBARE ZUSAMMENSETZUNG
UNE COMPOSITION PHOTODURCISSABLE

(30) Priority: 22.06.2020 WO PCT/CN2020/097364
(43) Date of publication of application: 26.04.2023
(73) Proprietor: Huntsman Advanced Materials Licensing (Switzerland) GmbH, 4057 Basel (CH)
(72) Inventor: SHU, Yiwan, Shanghai, 200245 (CN); WONG, Wancheong, Shanghai, 200245 (CN)
(74) Representative: Roberts, Philippa Grace
(86) International application number: PCT/EP2021/064906
(87) International publication number: WO 2021/259610

(56) References cited:
- DE-A1- 4 142 735
- US-B2- 8 716 413

## Description

### CROSS-REFERENCE TO RELATED APPLICATIONS

This application claims benefit of International Patent Application with Serial number PCT/CN2020/097364, filed June 22, 2020.

### FIELD

This disclosure relates generally to photocurable compositions and more specifically to photocurable compositions used in solder masks.

### BACKGROUND INFORMATION

The use of compositions containing epoxy resin and filler for solder mask applications is already known in the art. However, such compositions available in the art have less than desirable thermal aging resistance, crack resistance, and flux combability.

For instance, US6342547 discloses an epoxy composition using either fused silica or wollastonite as filler, but the example using fused silica shows poor cracking resistance performance.

US8999433 discloses an epoxy composition using both fused silica and wollastonite as filler, but the amount of the filler used in the composition is much higher than the amount that we intend to use, which may lead to poor solvent resistance.

US8716413B2 discloses a photocurable composition comprising an epoxy resin, a binder, a photopolymerization initiator and a a filler composition comprising silica and talc.

As such, there is a need for a photocurable composition with improved thermal aging resistance, crack resistance and flux compatibility over the photocurable compositions currently available.

### SUMMARY

It has now been surprisingly found that the compositions and processes of the present disclosure address the above problem. Advantages of the presently disclosed photocurable compositions include: (1) improved thermal aging resistance; (2) improved crack resistance; and/or (3) improved flux compatibility over current compositions.

The present disclosure is concerned with photocurable compositions with improved crack resistance over the prior art and processes for preparing these compositions. In one embodiment, the disclosure provides a photocurable composition comprising: (a) an epoxy resin comprising a compound having two or more epoxy groups per molecule; (b) a binder comprising a compound having at least one carboxyl group per molecule; (c) a photopolymerization initiator; and (d) a filler composition comprising silica, talc and wollastonite.

In another embodiment, the present disclosure provides a method for making an insulating layer by coating a substrate with the photocurable composition and then curing the photocurable composition.

In still another embodiment, the present disclosure provides an insulating layer comprising a substrate that has been coated by the photocurable composition of the present disclosure.

### DETAILED DESCRIPTION

If appearing herein, the term "comprising" and derivatives thereof are not intended to exclude the presence of any additional component, step or procedure, whether or not the same is disclosed herein. In order to avoid any doubt, all compositions claimed herein through use of the term "comprising" may include any additional additive, or compound, unless stated to the contrary. In contrast, the term, "consisting essentially of" if appearing herein, excludes from the scope of any succeeding recitation any other component, step or procedure, excepting those that are not essential to operability and the term "consisting of", if used, excludes any component, step or procedure not specifically delineated or listed. The term "or", unless stated otherwise, refers to the listed members individually as well as in any combination.

The articles "a" and "an" are used herein to refer to one or to more than one (i.e. to at least one) of the grammatical object of the article. By way of example, "a resin" means one resin or more than one resin.

The phrases "in one embodiment," "according to one embodiment," and the like generally mean the particular feature, structure, or characteristic following the phrase is included in at least one embodiment of the present invention, and may be included in more than one embodiment of the present invention. Importantly, such phrases do not necessarily refer to the same embodiment.

If the specification states a component or feature "may", "can", "could", or "might" be included or have a characteristic, that particular component or feature is not required to be included or have the characteristic.

The present disclosure generally provides a photocurable composition comprising: (a) an epoxy resin comprising a compound having two or more epoxy groups per molecule; (b) a binder comprising a compound having at least one carboxyl group per molecule; (c) a photopolymerization initiator; and (d) a filler composition comprising silica, talc and wollastonite.

Epoxy resins suitable as component (a) are those customary in epoxy resin technology. Non-limiting examples of epoxy resins are:
I) Polyglycidyl or poly(β-methylglycidyl) ethers, obtainable by reaction of a compound having at least two free alcoholic hydroxy groups and/or phenolic hydroxy groups with epichlorohydrin or β-methylepichlorohydrin under alkaline conditions or in the presence of an acid catalyst with subsequent alkali treatment. The glycidyl ethers of this kind are derived, for example, from acyclic alcohols, e.g. from ethylene glycol, diethylene glycol or higher poly(oxyethylene) glycols, propane-1,2-dial or poly(oxypropylene) glycols, propane-1,3-diol, butane-1,4-diol, poly(oxytetramethylene) glycols, pentane-1,5-diol, hexane-1,6-diol, hexane-2,4,6-triol, glycerol, 1,1,1-trimethylol-propane, pentaerythritol, sorbitol, and also from polyepichlorohydrins.
   Further glycidyl ethers of this kind are derived from cycloaliphatic alcohols, such as 1,4-cyclohexanedimethanol, bis(4-hydroxycyclohexyl) methane or 2,2-bis(4-hydroxycyclohexyl)propane, or from alcohols that contain aromatic groups and/or further functional groups, such as N,N-bis(2-hydroxyethyl)aniline or p,p'-bis(2-hydroxyethylamino)diphenylmethane. The glycidyl ethers can also be based on mononuclear phenols, for example resorcinol or hydroquinone, or on polynuclear phenols, for example bis(4-hydroxyphenyl)methane, 4,4'-dihydroxybiphenyl, bis(4-hydroxyphenyl)sulfone, 1,1,2,2-tetrakis(4-hydroxyphenyl)ethane, 2,2-bis(4-hydroxyphenyl)propane or 2,2-bis(3,5-dibromo-4-hydroxyphenyl) propane.
   Further hydroxy compounds that are suitable for the preparation of glycidyl ethers are novolaks, obtainable by condensation of aldehydes, such as formaldehyde, acetaldehyde, chloral or furfuraldehyde, with phenols or bisphenols that are unsubstituted or substituted by chlorine atoms or by C₁-C₉alkyl groups, e.g. phenol, 4-chlorophenol, 2-methylphenol or 4-tert-butylphenol.
II) Biphenyl epoxy resin (for example, YX4000 manufactured by Mitsubishi Chemical Corporation), biphenyl novolak epoxy resin (for example, NC-3000 manufactured by Nippon Kayaku Co., Ltd.), biphenylether epoxy resin (for example, YSLV-80XY manufactured by Nippon Steel & Sumikin Chemical Co., Ltd.), special two-functional epoxy resin (for example, YSLV-120TE manufactured by Nippon Steel & Sumikin Chemical Co., Ltd.) , dicyclopentadiene epoxy resin (for example, EPICLON HP-7200H manufactured by DIC Corporation, naphthalene epoxy resin (for example, EPICLON HP-4032, EPICLON HP-4700, EPICLON HP-4770 manufactured by DIC Corporation).
III) Polyglycidyl or poly(β-methylglycidyl) ethers, obtainable by reaction of a compound having at least two free alcoholic hydroxy groups and/or phenolic hydroxy groups with epichlorohydrin or β-methylepichlorohydrin under alkaline conditions or in the presence of an acid catalyst with subsequent alkali treatment. The glycidyl ethers of this kind are derived, for example, from acyclic alcohols, e.g. from ethylene glycol, diethylene glycol or higher poly(oxyethylene) glycols, propane-1,2-dial or poly(oxypropylene) glycols, propane-1,3-diol, butane-1,4-diol, poly(oxytetramethylene) glycols, pentane-1,5-diol, hexane-1,6-diol, hexane-2,4,6-triol, glycerol, 1,1,1-trimethylol-propane, pentaerythritol, sorbitol, and also from polyepichlorohydrins.
   Further glycidyl ethers of this kind are derived from cycloaliphatic alcohols, such as 1,4-cyclohexanedimethanol, bis(4-hydroxycyclohexyl) methane or 2,2-bis(4-hydroxycyclohexyl)propane, or from alcohols that contain aromatic groups and/or further functional groups, such as N,N-bis(2-hydroxyethyl)aniline or p,p'-bis(2-hydroxyethylamino)diphenylmethane. The glycidyl ethers can also be based on mononuclear phenols, for example resorcinol or hydroquinone, or on polynuclear phenols, for example bis(4-hydroxyphenyl)methane, 4,4'-dihydroxybiphenyl, bis(4-hydroxyphenyl)sulfone, 1,1,2,2-tetrakis(4-hydroxyphenyl)ethane, 2,2-bis(4-hydroxyphenyl)propane or 2,2-bis(3,5-dibromo-4-hydroxyphenyl) propane.
   Further hydroxy compounds that are suitable for the preparation of glycidyl ethers are novolaks, obtainable by condensation of aldehydes, such as formaldehyde, acetaldehyde, chloral or furfuraldehyde, with phenols or bisphenols that are unsubstituted or substituted by chlorine atoms or by C₁-C₉alkyl groups, e.g. phenol, 4-chlorophenol, 2-methylphenol or 4-tert-butylphenol.
IV) Poly(N-glycidyl) compounds, obtainable by dehydrochlorination of the reaction products of epichlorohydrin with amines containing at least two amine hydrogen atoms. Such amines are, for example, aniline, n-butylamine, bis(4-aminophenyl)methane, m-xylylenediamine or bis(4-methylaminophenyl)methane. The poly(N-glycidyl) compounds also include, however, triglycidyl isocyanurate, N,N'-diglycidyl derivatives of cycloalkyleneureas, such as ethyleneurea or 1,3-propyleneurea, and diglycidyl derivatives of hydantoins, such as of 5,5-dimethylhydantoin.
V) Cycloaliphatic epoxy resins, e.g. bis(2,3-epoxycyclopentyl)ether, 2,3-epoxycyclopentylglycidyl ether, 1,2-bis(2,3-epoxycyclopentyloxy) ethane or 3,4-epoxycyclohexyl methyl-3',4'-epoxycyclohexanecarboxylate.

It is also possible, however, to use epoxy resins wherein the 1,2-epoxy groups are bonded to different hetero atoms or functional groups; such compounds include, for example, the N,N,O-triglycidyl derivative of 4-aminophenol, the glycidyl ether glycidyl ester of salicylic acid, N-glycidyl-N'-(2-glycidyloxypropyl)-5,5-dimethylhydantoin and 2-glycidyloxy-1,3-bis(5,5-dimethyl-1-glycidylhydantoin-3-yl)propane.

The term "cycloaliphatic epoxy resin" in the context of this disclosure denotes any epoxy resin having cycloaliphatic structural units, that is to say it includes both cycloaliphatic glycidyl compounds and β-methylglycidyl compounds as well as epoxy resins based on cycloalkylene oxides.

Suitable cycloaliphatic glycidyl compounds and β-methylglycidyl compounds are the glycidyl esters and β-methylglycidyl esters of cycloaliphatic polycarboxylic acids, such as tetrahydrophthalic acid, 4-methyltetrahydrophthalic acid, hexahydrophthalic acid, 3-methylhexahydrophthalic acid and 4-methylhexahydrophthalic acid. Further suitable cycloaliphatic epoxy resins are the diglycidyl ethers and β-methylglycidyl ethers of cycloaliphatic alcohols, such as 1,2-dihydroxycyclohexane, 1,3-dihydroxycyclohexane and 1,4-dihydroxycyclohexane, 1,4-cyclohexanedimethanol, 1,1-bis(hydroxymethyl) cyclohex-3-ene, bis(4-hydroxycyclohexyl)methane, 2,2-bis(4-hydroxycyclohexyl)propane and bis(4-hydroxycyclohexyl)sulfone.

Examples of epoxy resins having cycloalkylene oxide structures are bis(2,3-epoxycyclopentyl)ether, 2,3-epoxy cyclopentylglycidyl ether, 1,2-bis(2,3-epoxycyclopentyl)ethane, vinyl cyclohexene dioxide, 3,4-epoxycyclohexylmethyl 3',4'-epoxycyclohexanecarboxylate, 3,4-epoxy-6-methylcyclohexylmethyl-3',4'-epoxy-6'-methylcyclohexanecarboxylate, bis(3,4-epoxycyclohexylmethyl)adipate and bis(3,4-epoxy-6-methylcyclohexylmethyl)adipate. Preferred cycloaliphatic epoxy resins are bis(4-hydroxycyclohexyl) methanediglycidyl ether, 2,2-bis(4-hydroxycyclohexyl)propanediglycidyl ether, tetrahydrophthalic acid diglycidyl ester, 4-methyltetrahydrophthalic acid diglycidyl ester, 4-methylhexahydrophthalic acid diglycidyl ester, 3,4-epoxy cyclohexylmethyl 3',4'-epoxycyclohexanecarboxylate and especially hexahydrophthalic acid diglycidyl ester.

Aliphatic epoxy resins can also be used as the epoxy resin for component (a). Aliphatic epoxy resins include, for example but without limitation, epoxidation products of unsaturated fatty acid esters. If using epoxidation products of unsaturated fatty acid esters as the epoxy resin for component (a), it is preferable to use epoxy-containing compounds derived from mono-and poly-fatty acids having from 12 to 22 carbon atoms and an iodine number of from 30 to 400, for example lauroleic acid, myristoleic acid, palmitoleic acid, oleic acid, gadoleic acid, erucic acid, ricinoleic acid, linoleic acid, linolenic acid, elaidic acid, licanic acid, arachidonic acid and clupanodonic acid.

Non-limiting examples of suitable epoxidation products of unsaturated fatty acid esters for component (a) are the epoxidation products of soybean oil, linseed oil, perilla oil, tong oil, oiticica oil, safflower oil, poppyseed oil, hemp oil, cottonseed oil, sunflower oil, rapeseed oil, polyunsaturated triglycerides, triglycerides from euphorbia plants, groundnut oil, olive oil, olive kernel oil, almond oil, kapok oil, hazelnut oil, apricot kernel oil, beechnut oil, lupin oil, maize oil, sesame oil, grapeseed oil, lallemantia oil, castor oil, herring oil, sardine oil, menhaden oil, whale oil, tall oil and derivatives thereof.

Also suitable as the epoxy resin are higher unsaturated derivatives that can be obtained by subsequent dehydrogenation reactions of those oils.

The olefinic double bonds of the unsaturated fatty acid radicals of the above-mentioned compounds can be epoxidised in accordance with known methods, for example by reaction with hydrogen peroxide, optionally in the presence of a catalyst, an alkyl hydroperoxide or a peracid, for example performic acid or peracetic acid. Within the scope of the present disclosure, both the fully epoxidised oils and the partially epoxidised derivatives that still contain free double bonds can be used for component (a).

Preference is given to the use of epoxidised soybean oil and epoxidised linseed oil. Mixtures of epoxy resins I) to V) mentioned above can also be used. The photocurable composition according to the present disclosure preferably comprises as component (a) an aromatic or cycloaliphatic glycidylether or glycidylester that is liquid or solid at 25°C, preferably the diglycidylether or diglycidylester of bisphenol A or bisphenol F. Preferred epoxy resins can also be obtained by the reaction of polyglycidylether and polyglycidylester with alcohols, such as diols. The reaction with diols increases the molecular weight. Especially preferred is an epoxy resin which is a bisphenol A glycidylether which is reacted with less than an equimolar amount of bisphenol A.

According to a preferred embodiment the photocurable composition comprises an epoxy resin selected from the group consisting of polyglycidylester, poly(β-methylglycidyl)ester, polyglycidylether, poly(β-methylglycidyl)ether and mixtures thereof.

According one embodiment, 40 to 80% by weight of said epoxy resin comprises a biphenyl type epoxy resin having an epoxy equivalent of 150 to 450 g/mol.

According to another embodiment, 20 to 40% by weight of said epoxy resin comprises a bisphenol A type epoxy resin having an epoxy equivalent of 175 to 210 g/mol. According to one embodiment, the epoxy resin is present in the photocurable composition in an amount ranging from about 5 wt.% to about 30 wt.%, or preferably from about 5 wt.% to about 15 wt.% based on the total weight of the photocurable composition.

In one embodiment, the binder comprising a compound having at least one carboxyl group per molecule (i.e., component (b)) comprises a mixture of (i) one or more of a cresol novolac resin, or an aromatic epoxy resin and (ii) one or more of a carboxyl functional polyester resin, a carboxyl functional acrylic resin, or a glycidyl functional acrylic resin. The carboxyl functional acrylic resin, and glycidyl functional acrylic resin comprise alkyl (meth)acrylates. Non-limiting examples of the alkyl (meth)acrylates include methyl acrylate, methyl methacrylate, ethyl acrylate, acrylic acid, methacrylic acid, butyl acrylate, and butyl methacrylate.

The weight average molecular weight (Mw) of the binder ranges from 1,000 to 80,000 Daltons, preferably from 2,000 to 40,000 Daltons.

Molecular weight (MW) is weight average molecular weight which is defined by Gel Permeation Chromatography (GPC) method with polystyrene as a reference.

In another embodiment, component (b) (i.e., the binder comprising a compound having at least one carboxyl group per molecule) is obtained by reacting a cresol novolac type epoxy compound and an unsaturated monocarboxylic acid with a saturated or unsaturated polybasic acid anhydride. The saturated or unsaturated polybasic acid anhydride which is unreacted is then reacted with a hydroxyl group-containing monomer to eliminate the saturated or unsaturated polybasic acid anhydride.

In yet another embodiment, the component (b) is obtained by reacting a bisphenol A epoxy acrylate with a diisocyanate. The diisocyanate may be any commonly available diisocyanate, such as hexamethylene diisocyanate (HDI), isophorone diisocyanate (IPDI), methylene diisocyanate (MDI), methylenebiscyclohexylisocyanate, trimethylhexamethyl diisocyanate, hexane diisocyanate, hexamethylamine diisocyanate, methylenebiscyclohexyl isocyanate, toluene diisocyanate, 1,2-diphenylethane diisocyanate, 1,3-diphenylpropane diisocyanate, diphenylmethane diisocyanate, dicyclohexylmethyl diisocyanate, etc. Preferably, for maximum flexibility of the oligomer, the diisocyanate is an aliphatic diisocyanate such as HDI. At this point, the molecule has diisocyanate functionality.

According to one embodiment, the binder comprising a compound having at least one carboxyl group per molecule is present in the photocurable composition in an amount ranging from about 10 wt.% to about 60 wt.%, preferably from about 30 wt.% to about 50 wt.% based on the total weight of the photocurable composition.

In one embodiment, the binder comprising a compound having at least one carboxyl group per molecule has an acid value greater than or equal to 40 mg KOH/g. Preferably, the acid value of the binder comprising a compound having at least one carboxyl group per molecule is greater than or equal to 60 mg KOH/g. In addition, the acid value of the binder comprising a compound having at least one carboxyl group per molecule is preferably less than or equal to 120 mg KOH/g, or more preferably less than or equal to 100 mg KOH/g.

In another embodiment, the photopolymerization initiator of the present disclosure is a free-radical photoinitiator. Typical representatives of free-radical photoinitiators are benzoins, such as benzoin, benzoin ethers, such as benzoin methyl ether, benzoin ethyl ether and benzoin isopropyl ether, benzoin phenyl ether and benzoin acetate, acetophenones, such as acetophenone, 2,2-dimethoxy-acetophenone and 1,1-dichloroacetophenone, benzil, benzil ketals, such as benzil dimethylketal and benzil diethyl ketal, anthraquinones, such as 2-methylanthraquinone, 2-ethylanthra-quinone, 2-tert-butylanthraquinone, 1-chloroanthraquinone and 2-amylanthraquinone, and also triphenylphosphine, benzoylphosphine oxides, for example 2,4,6-trimethylbenzoyl-diphenylphosphine oxide (Luzirin^{®} TPO), bisacylphosphine oxides, benzophenones, such as benzophenone and 4,4'-bis(N,N'-dimethylamino)benzophenone, thioxanthones and xanthones, acridine derivatives, phenazine derivatives, quinoxaline derivatives or 1-phenyl-1,2-propanedione 2-O-benzoyl oxime, 1-aminophenyl ketones or 1-hydroxy phenyl ketones, such as 1-hydroxycyclohexyl phenyl ketone, phenyl 1-hydroxyisopropyl ketone and 4-isopropylphenyl 1-hydroxyisopropyl ketone.

Preferably, the free radical photoinitiator is 2-benzyl-2-dimethylamino-1-(4-morpholinophenyl) -butanone-1, 2,4,6-trimethylbenzoyl-diphenylphosphine oxide, 2-isopropylthioxanthone, or a mixture thereof.

According to one embodiment, the photopolymerization initiator is present in the photocurable composition in an amount ranging from about 1 wt.% to about 10 wt.%, preferably from about 2 wt.% to about 6 wt.% based on the total weight of the photocurable composition.

An essential component of the photocurable composition according to the present disclosure is a filler composition comprising silica, talc and wollastonite. The filler composition can optionally further include at least one of barium sulfate and Kaolin. Silica is an oxide of silicon with the chemical formula SiO₂.

According to a preferred embodiment, the silica is amorphous silica. Preferably the amorphous silica is natural amorphous silica or fused silica.

According to a preferred embodiment the amorphous silica has an average particle size (d₅₀) of 1 to 100 µm, more preferably from 2 to 50 µm and most preferably from 2 to 10 µm determined according to ISO 13320-1:1999.

D₅₀ is known as the medium value of particle diameter. This means that a powder comprises 50% of particles having a larger particle size and 50% of particles having a smaller particle size than the d₅₀ value. D₉₅ means that 95% of the particles have a smaller particle size and 5% of the particles have a larger particle size than the d₉₅ value.

Preferably, the amorphous silica is surface treated. Preferably, the amorphous silica is surface treated with a silane, more preferably selected from the group consisting of amino silane, epoxy silane, (meth)acrylic silane, methyl silane and vinyl silane.

Preferably the silane is (meth)acrylic silane.

Talc is a clay mineral composed of hydrated magnesium silicate with the chemical formula Mg₃Si₄O₁₀(OH)₂. Talc in powdered form is widely used as filler. Talc is commercially available, for example under the name FH105 from Fuji TALC INDUSTRIAL Co., Ltd. Preferably, the talc is surface treated. Preferably, the talc is surface treated with a silane, more preferably selected from the group consisting of amino silane, epoxy silane, (meth)acrylic silane, methyl silane and vinyl silane.

Preferably the silane is (meth)acrylic silane.

The third essential filler component is wollastonite. Wollastonite is a naturally occurring acicular calcium silicate of the formula Ca₃[Si₃O₉] having particle sizes in the micron range. Artificially produced wollastonite is also acicular. Wollastonite is commercially available, for example under the name Nyad^{®} from the Nyco Company or under the name TREMIN^{®} from Quarzwerke, Germany, e.g., TREMIN^{®} 283-100EST or TREMIN^{®} 283-600EST. According to a preferred embodiment the wollastonite is a powder preferably having an average particle size d₅₀ of 1 to 100 µm, more preferably from 3 to 50 µm and most preferably from 2 to 15 µm determined according to ISO 13320-1:1999.

Further preferred is a photocurable composition wherein the wollastonite has a particle size d₉₅ of 1 to 200 µm, more preferably from 2 to 100 µm and most preferably from 3 to 20 µm determined according to ISO 13320-1:1999.

The wollastonite preferably has a bulk density of 0.40 to 0.90 g/cm³, more preferably from 0.49 to 0.80 g/cm³ and most preferably from 0.55 to 0.76 g/cm³ determined according to DIN 52466.

Especially preferred is wollastonite having a specific surface BET of 2 to 5 m²/g determined according to DIN 66132.

The photocurable composition according to the present disclosure preferably comprises wollastonite which is surface treated. Preferably, the wollastonite is surface treated with a silane, preferably selected from the group consisting of aminosilane, epoxysilane, (meth)acrylic silane, methylsilane and vinylsilane.

Preferably the silane is (meth)acrylic silane.

According to one embodiment, the filler composition is present in the photocurable composition in an amount ranging from about 20 wt.% to about 50 wt.%, preferably from about 30 wt.% to about 39 wt.% based on the total weight of the photocurable composition. In another embodiment, the photocurable composition may further optionally comprise acrylate monomer, curing agent, coupling agent, defoamer, fire retardants, antioxidants, solvents, surfactants, pigments, polymerization inhibitor, stabilizer or any other typical additives used in epoxy resin materials.

Advantages of the presently disclosed photocurable composition include: (1) improved thermal aging resistance; (2) improved crack resistance; and/or (3) improved flux compatibility over the prior art.

The present disclosure also provides a method for forming an insulating layer comprising: coating a substrate with the photocurable composition as disclosed herein; preliminary drying the coated substrate at about 70°C to 80°C for about 30 to 90 minutes; irradiating the coated substrate with an active energy; heat curing the coated substrate a first time at about 20°C to 40°C for about 30 to 120 seconds; dissolving and eliminating the unexposed area of the coated substrate; and heat curing the coated substrate a second time at about 100°C to 200°C for about 30 to 120 minutes.

Furthermore, the present disclosure also provides an insulating layer produced by the method described herein.

The examples which now follow should be considered exemplary of the present disclosure, and not limiting in any way.

### Raw Materials

**Solvent 1:** ethyl diglycol acetate (Supplier: Polynt, UK);
**Solvent 2:** DOWANOL^{®} PMA propylene glycol monomethyl ether acetate (Supplier: The Dow Chemical Company, USA);
**Binder 1:** PR-3000 a carboxyl group-containing modified cresol novolac epoxy acrylate (Supplier: Showa Denka highpolymer Cop. Shanghai);
**Binder 2:** KAYARAD^{®} UXE-3000 acid modified epoxy acrylate (Supplier: Nippon Kayaku, Japan);
**Binder 3:** CYCLOMER^{®} PACAZ-250 acid modified acrylate copolymer (Supplier: Daicel Corporation, Japan);
**Photoinitiator 1:** IRGACURE^{®} 369 2-benzyl-2-(dimethylamino)-1-[4-(morpholinyl) phenyl)]-1-butanone (Supplier: IGM);
**Photoinitiator 2:** IHT-PI TPO diphenyl (2,4,6-trimethylbenzoyl)-phosphine oxide (Supplier: Insight High Technology);
**Photoinitiator 3:** IHT-PI ITX 2-isopropylthioxanthone (Supplier: Insight High Technology);
**Photoinitiator 4:** IRGACURE^{®} OXE02 ethanone, 1-[9-ethyl-6-(2-methylbenzoyl)-9H-carbazol-3-yl]-, 1-(O-acetyloxime) (Supplier: BASF, Germany);
**Photoinitiator 5:** JMT-784 bis (eta 5-2,4-cyclopentadien-1-yl) bis [2,6-difluoro-3-(1H-pyrrol-1-yl) phenyl]titanium (Supplier: Yueyang Kimoutain Sci-tech);
**Acrylate monomer 1:** SR444NS pentaerythritol triacrylate (Supplier: Sartomer);
**Acrylate monomer 2:** KAYARAD^{®} DPCA-60 ethoxylated dipentaerythritol hexaacrylate (Supplier: Nippon Kayaku, Japan);
**Acrylate monomer 3:** ETERMER^{®} 2308 tris(2-hydroxyethyl) isocyanurate triacrylate (Supplier: Eternal);
**Curing agent 1:** 1-cyanoguanidine (Supplier: Alzchem Trostberg, Germany);
**Curing agent 2:** DYHARD^{®} UR300 Fenuron (Supplier: Alzchem Trostberg, Germany);
**Curing agent 3:** 2,4,6,-triamino-1,3,5,-triazine (Supplier: Sichuan Yunong Chemical);
**Epoxy 1:** NC-3000 biphenyl novolak epoxy resin (Supplier: Nippon Kayaku, Japan);
**Epoxy 2:** jER YX-4000k 2,2'- ((3,3',5,5'- tetramethyl- (1,1'- biphenyl)- 4,4'- diyl)- bis (oxymethylene))-bis-oxirane (Supplier: Mitsubishi Chemical Corporation, Japan)
**Epoxy 3:** ARALDITE^{®} GY 2600 bisphenol A epoxy resin (Supplier: Huntsman Advanced Materials, Switzerland);
**Pigment 1:** Pigment Yellow 147 (Supplier: BASF, Germany);
**Pigment 2:** Pigment Blue 15:4 (Supplier: ChemFine International);
**Coupling agent:** SLIQUEST^{®} A-174 γ-methacryloxypropyl trimethoxy silane (Supplier: Momentive);
**Antioxidant:** IRGANOX^{®} 1010 pentaerythritol tetrakis(3-(3,5-di-tert-buty-4-hydroxuphenyl) propionate) (Supplier: BASF, Germany);
**Polymerization inhibitor:** dihydroxy-1,4 benzene (Supplier: Rhodia);
**Defoamer:** KSZ-66 silicone oil (Supplier: Shinetsu Silicone);
**Filler 1:** MEGASIL^{™} 525 fused silica (Supplier: Sibelco);
**Filler 2:** TIKRON^{®} 1363-800EST TALC which is surface treated with epoxy silane (Supplier: Quarzwerke Group);
**Filler 3:** TIKRON^{®} 1363-800MST TALC which is surface treated with acrylate silane (Supplier: Quarzwerke Group);
**Filler 4:** TREMIN^{®} 283-600EST wollastonite which is surface treated with epoxy silane (Supplier: Quarzwerke Group);
**Filler 5:** TREMIN^{®} 283-600MST wollastonite which is surface treated with acrylate silane (Supplier: Quarzwerke Group);
**Filler 6:** Barium sulfate B34 (Supplier: Sakai Chemical);
**Filler 7:** POLARITE^{®} 102A Kaolin (Supplier: Imerys)

### Examples 1-15:

The components for Examples 1 through 15 are shown in Table 1. All values listed in Table 1 refer to parts by weight of the photocurable composition. As shown in Table 1, Examples 8 to 15 were comparative examples that contained filler compositions not from the present disclosure.

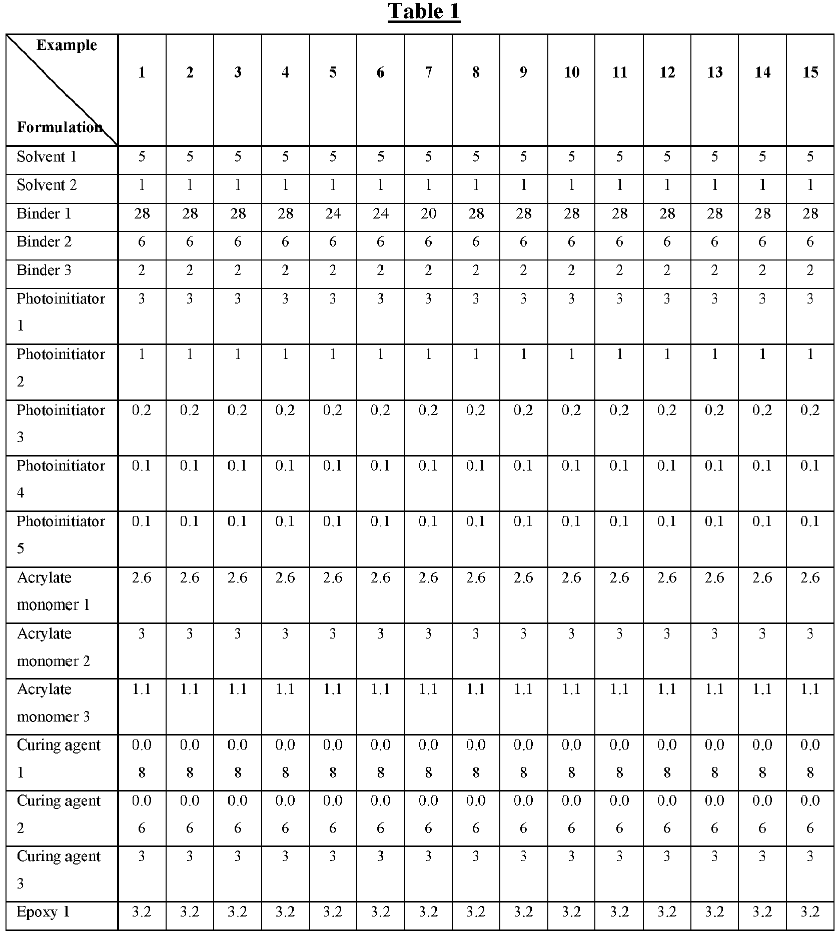

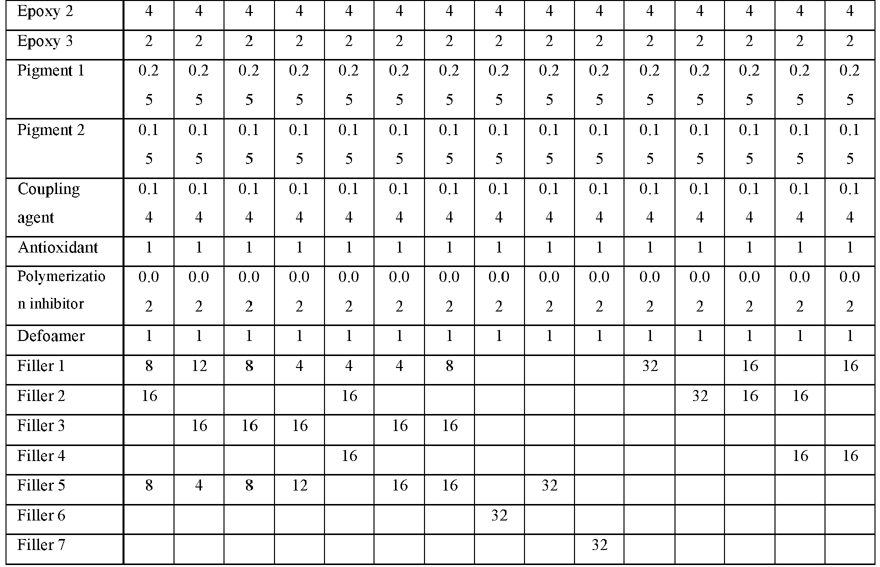

### Procedure

Examples 1-15 were prepared by combining the components and mixing at room temperature until the mixture was homogeneous and milled by triple roll machine. A glass fiber epoxy copper-clad laminated plate including a copper foil with thickness of 50 µm was prepared. A designed pattern was formed by etching on the epoxy copper-clad laminated plate to obtain a core material. A surface of the obtained core material was entirely coated with the photocurable composition by a screen printing method, which was then dried by heating at 75 °C for 40 minutes to obtain a coating with thickness of 25µm. With a negative mask placed directly on the coating, the negative mask was irradiated with ultraviolet rays using an exposing device equipped with a metal halide lamp, and accordingly the coating was selectively exposed to light with 400 mJ / cm² of exposure. Then, the negative mask was removed from the coating, and the coating was developed with 1.0% a sodium carbonate aqueous solution at a temperature about 28-32°C for 90s so that a part of the coating, which was cured due to exposure to light, remained as a solder mask layer on a printed circuit board. The solder mask layer was further heated at 150 °C for 60 minutes and thermal curing. As a result, a test piece including the solder mask layer was obtained.

### Results

### Physical Property

**Table 2**

| **Example** | **1** | **2** | **3** | **4** | **5** | **6** | **7** | **8** | **9** | **10** | **11** | **12** | **13** | **14** | **15** |
|---|---|---|---|---|---|---|---|---|---|---|---|---|---|---|---|
| **Hardness¹⁾** | 5H | 5H | 5H | 5H | 6H | 6H | 6H | 7H | 8H | 8H | 8H | 3H | 5H | 5H | 5H |
| **Solvent resistance**²⁾ **(CH₂Cl₂ for 30 min)** | P | P | P | P | P | P | Blister | Color change | P | Serious blister | P | Serious blister | P | P | P |
| **Flux compatibility**³⁾ **(flux: HAR-809K)** | P | P | P | P | P | P | P | Peeling | P | Peeling | P | P | P | P | P |
| **Thermal aging⁴⁾ (160°C for 1000 hours)** | GT0-1 | GT0-1 | GT0-1 | GT0-1 | GT1 | GT0-1 | GT0-1 | GT2 | GT1 | GT2 | GT1 | GT0-1 | GT1 | GT1 | GT1 |
| **Thermal aging⁴⁾ (160°C for 2000 hours)** | GT1 | GT1 | GT1 | GT1 | GT1 | GT1 | GT1 | GT5 | GT5 | GT5 | GT5 | GT1 | GT1 | GT1 | GT1 |
| **Crack resistance⁵⁾ (1000 cycles)** | 0.6% | 0 | 0 | 0 | 5.9% | 3% | 0 | 100% | 2.4% | 40.5% | 25.6% | 0 | 10.1% | 6.5% | 16.1% |
| **Crack resistance⁵⁾ (2000 cycles)** | 8.3% | 7.1% | 3.6% | 3% | 12.5% | 8.9% | 1.2% | 100% | 22.6% | 100% | 42.3% | 3.6% | 17.3% | 13.7% | 33.3% |

| | | | | | | | | | | | | | | | |
|---|---|---|---|---|---|---|---|---|---|---|---|---|---|---|---|
| 1) Tested according to IPC-TM-650 2.4.27.2, pencil hardness; Target >=5H 2) Tested according to IPC-TM-650 2.3.42; Target: no blister or color change 3) Tested according to IPC-TM-650 2.4.6; Target: no peeling 4) Tested according to ISO 2409; Target GT0 or GT1 5) The board for evaluation was placed in a cold-hot chamber which has a working temperature cycle between -40°C and 160°C to carry out crack resistance test. Each cycle takes 30 minutes and there is 10 seconds break between each cycle. Appearance of the board was observed after 1000 cycles and 2000 cycles by 100x magnifier. Crack rate is calculated for the cracked corners among all the corners of the board. The crack resistance test was also called Thermal Cycle Test (TCT) which is performed according to a method known in the art (see for example patent application US2012125672). P = test passed | | | | | | | | | | | | | | | |

Table 2 shows the physical property for Examples 1 - 15. For Examples 1 to 7 the composition has improved thermal aging resistance, crack resistance and flux compatibility. However, when the amount of filler composition is too high (Example 7), there is impact on the solvent resistance performance. The composition using acrylate silane treated filler has better crack resistance than the composition using epoxy silane treated filler (Example 5). The compositions using only one filler (Example 8-12) or two fillers (Example 13-15) has poor solvent resistance or crack resistance, which cannot meet the requirements for solder mark application.

## Claims

1. A photocurable composition comprising:
(a) an epoxy resin comprising a compound having two or more epoxy groups per molecule;
(b) a binder comprising a compound having at least one carboxyl group per molecule;
(c) a photopolymerization initiator; and
(d) a filler composition comprising silica, talc, and wollastonite.

2. The photocurable composition of claim 1, wherein said epoxy resin comprises a biphenyl type epoxy resin having an epoxy equivalent of 150 to 450 g/mol.

3. The photocurable composition of claim 2, wherein 40 to 80% by weight of said epoxy resin comprises a biphenyl type epoxy resin having an epoxy equivalent of 150 to 450 g/mol.

4. The photocurable composition of any one of claims 1-3, wherein said epoxy resin comprises a bisphenol A type epoxy resin having an epoxy equivalent of 175 to 210 g/mol.

5. The photocurable composition of any one of claims 1-4, wherein 20 to 40% by weight of said epoxy resin comprises a bisphenol A type epoxy resin having an epoxy equivalent of 175 to 210 g/mol.

6. The photocurable composition of any one of claims 1-5, wherein epoxy resin is present in the photocurable composition in an amount ranging from about 5% by weight to about 30% by weight, preferably from about 5% by weight to about 15% by weight based on the total weight of the photocurable composition.

7. The photocurable composition of any one of claims 1-6, wherein the binder comprising a compound having at least one carboxyl group per molecule is present in the photocurable composition in an amount ranging from about 10% by weight to about 60% by weight, preferably from about 30% by weight to about 50% by weight based on the total weight of the photocurable composition.

8. The photocurable composition of any one of claims 1-7, wherein the photopolymerization initiator is present in the photocurable composition in an amount ranging from about 1% by weight to about 10% by weight, preferred from about 3% by weight to about 5% weight based on the total weight of the photocurable composition.

9. The photocurable composition of any one of claims 1-8, wherein the silica is amorphous silica.

10. The photocurable composition of any one of claims 1-9, wherein the filler composition is present in the photocurable composition in an amount ranging from about 20% by weight to about 50% by weight, preferably from about 30% by weight to about 38% by weight based on the total weight of the photocurable composition.

11. A method for forming an insulating layer comprising: coating a substrate with the photocurable composition of claim 1-10; preliminary drying the coated substrate at about 70°C to 80°C for about 30 to 90 minutes; irradiating the coated substrate with an active energy; heat curing the coated substrate a first time at about 20°C to 40°C for about 30 to 120 seconds; dissolving and eliminating the unexposed area of the coated substrate; and heat curing the coated substrate a second time at about 100°C to 200°C for about 30 to 120 minutes.

12. An insulating layer produced by the method of claim 11.

## Patentansprüche

1. Photohärtbare Zusammensetzung, umfassend:
(a) ein Epoxidharz, das eine Verbindung mit zwei oder mehr Epoxidgruppen pro Molekül umfasst;
(b) ein Bindemittel, das eine Verbindung umfasst, die mindestens eine Carboxylgruppe pro Molekül aufweist;
(c) einen Photopolymerisationsinitiator; und
(d) eine Füllstoffzusammensetzung, die Siliciumdioxid, Talk und Wollastonit umfasst.

2. Photohärtbare Zusammensetzung nach Anspruch 1, wobei das Epoxidharz ein Epoxidharz vom Biphenyltyp mit einem Epoxidäquivalent von 150 bis 450 g/mol umfasst.

3. Photohärtbare Zusammensetzung nach Anspruch 2, wobei 40 bis 80 Gewichts-% des Epoxidharzes ein Epoxidharz vom Biphenyltyp mit einem Epoxidäquivalent von 150 bis 450 g/mol umfassen.

4. Photohärtbare Zusammensetzung nach einem der Ansprüche 1 bis 3, wobei das Epoxidharz ein Epoxidharz vom Bisphenol A-Typ mit einem Epoxidäquivalent von 175 bis 210 g/mol umfasst.

5. Photohärtbare Zusammensetzung nach einem der Ansprüche 1 bis 4, wobei 20 bis 40 Gewichts-% des Epoxidharzes ein Epoxidharz vom Bisphenol A-Typ mit einem Epoxidäquivalent von 175 bis 210 g/mol umfassen.

6. Photohärtbare Zusammensetzung nach einem der Ansprüche 1 bis 5, wobei Epoxidharz in der photohärtbaren Zusammensetzung in einer Menge im Bereich von etwa 5 Gewichts-% bis etwa 30 Gewichts-%, bevorzugt von etwa 5 Gewichts-% bis etwa 15 Gewichts-%, bezogen auf das Gesamtgewicht der photohärtbaren Zusammensetzung, vorhanden ist.

7. Photohärtbare Zusammensetzung nach einem der Ansprüche 1 bis 6, wobei das Bindemittel, das eine Verbindung mit mindestens einer Carboxylgruppe pro Molekül umfasst, in der photohärtbaren Zusammensetzung in einer Menge im Bereich von etwa 10 Gewichts-% bis etwa 60 Gewichts-%, bevorzugt von etwa 30 Gewichts-% bis etwa 50 Gewichts-%, bezogen auf das Gesamtgewicht der photohärtbaren Zusammensetzung, vorhanden ist.

8. Photohärtbare Zusammensetzung nach einem der Ansprüche 1 bis 7, wobei der Photopolymerisationsinitiator in der photohärtbaren Zusammensetzung in einer Menge im Bereich von etwa 1 Gewichts-% bis etwa 10 Gewichts-%, bevorzugt von etwa 3 Gewichts-% bis etwa 5 Gewichts-%, bezogen auf das Gesamtgewicht der photohärtbaren Zusammensetzung, vorhanden ist.

9. Photohärtbare Zusammensetzung nach einem der Ansprüche 1 bis 8, wobei es sich bei dem Siliciumdioxid um amorphes Siliciumdioxid handelt.

10. Photohärtbare Zusammensetzung nach einem der Ansprüche 1 bis 9, wobei die Füllstoffzusammensetzung in der photohärtbaren Zusammensetzung in einer Menge im Bereich von etwa 20 Gewichts-% bis etwa 50 Gewichts-%, bevorzugt von etwa 30 Gewichts-% bis etwa 38 Gewichts-%, bezogen auf das Gesamtgewicht der photohärtbaren Zusammensetzung, vorhanden ist.

11. Verfahren zum Bilden einer Isolierschicht, umfassend: das Beschichten eines Substrats mit der photohärtbaren Zusammensetzung nach Anspruch 1 bis 10; Vortrocknen des beschichteten Substrats bei etwa 70 °C bis 80 °C für etwa 30 bis 90 Minuten; Bestrahlen des beschichteten Substrats mit einer Wirkenergie; erstes Wärmehärten des beschichteten Substrats bei etwa 20 °C bis 40 °C für etwa 30 bis 120 Sekunden; Auflösen und Entfernen des unbelichteten Bereichs des beschichteten Substrats; und zweites Wärmehärten des beschichteten Substrats bei etwa 100 °C bis 200 °C für etwa 30 bis 120 Minuten.

12. Isolierschicht, hergestellt durch das Verfahren nach Anspruch 11.

## Revendications

1. Composition photodurcissable comprenant :
(a) une résine époxy comprenant un composé ayant deux groupes époxy ou plus par molécule ;
(b) un liant comprenant un composé ayant au moins un groupe carboxyle par molécule ;
(c) un initiateur de photopolymérisation ; et
(d) une composition de charge comprenant de la silice, du talc et de la wollastonite.

2. Composition photodurcissable selon la revendication 1, dans laquelle ladite résine époxy comprend une résine époxy de type biphényle ayant un équivalent époxy de 150 à 450 g/mol.

3. Composition photodurcissable selon la revendication 2, dans laquelle 40 à 80 % en poids de ladite résine époxy comprennent une résine époxy de type biphényle ayant un équivalent époxy de 150 à 450 g/mol.

4. Composition photodurcissable selon l'une quelconque des revendications 1 à 3, dans laquelle ladite résine époxy comprend une résine époxy de type bisphénol A ayant un équivalent époxy de 175 à 210 g/mol.

5. Composition photodurcissable selon l'une quelconque des revendications 1 à 4, dans laquelle 20 à 40 % en poids de ladite résine époxy comprennent une résine époxy de type bisphénol A ayant un équivalent époxy de 175 à 210 g/mol.

6. Composition photodurcissable selon l'une quelconque des revendications 1 à 5, dans laquelle la résine époxy est présente dans la composition photodurcissable en une quantité allant d'environ 5 % en poids à environ 30 % en poids, de préférence d'environ 5 % en poids à environ 15 % en poids sur la base du poids total de la composition photodurcissable.

7. Composition photodurcissable selon l'une quelconque des revendications 1 à 6, dans laquelle le liant comprenant un composé ayant au moins un groupe carboxyle par molécule est présent dans la composition photodurcissable en une quantité allant d'environ 10 % en poids à environ 60 % en poids, de préférence d'environ 30 % en poids à environ 50 % en poids sur la base du poids total de la composition photodurcissable.

8. Composition photodurcissable selon l'une quelconque des revendications 1 à 7, dans laquelle l'initiateur de photopolymérisation est présent dans la composition photodurcissable en une quantité allant d'environ 1 % en poids à environ 10 % en poids, de préférence d'environ 3 % en poids à environ 5 % en poids sur la base du poids total de la composition photodurcissable.

9. Composition photodurcissable selon l'une quelconque des revendications 1 à 8, dans laquelle la silice est une silice amorphe.

10. Composition photodurcissable selon l'une quelconque des revendications 1 à 9, dans laquelle la composition de charge est présente dans la composition photodurcissable en une quantité allant d'environ 20 % en poids à environ 50 % en poids, de préférence d'environ 30 % en poids à environ 38 % en poids sur la base du poids total de la composition photodurcissable.

11. Procédé de formation d'une couche isolante comprenant : le revêtement d'un substrat avec la composition photodurcissable selon les revendications 1 à 10 ; le séchage préalable du substrat revêtu à environ 70 °C à 80 °C pendant environ 30 à 90 minutes; l'irradiation du substrat revêtu avec une énergie active ; le durcissement thermique du substrat revêtu une première fois à environ 20 °C à 40 °C pendant environ 30 à 120 secondes ; la dissolution et l'élimination de la zone non exposée du substrat revêtu ; et le durcissement thermique du substrat revêtu une seconde fois à environ 100 °C à 200 °C pendant environ 30 à 120 minutes.

12. Couche isolante produite par le procédé selon la revendication 11.
